# EUROPEAN PATENT SPECIFICATION

(11) **EP 3 654 094 B1**
(45) Date of publication and mention of the grant of the patent: **07.06.2023**
(21) Application number: 18206384.2
(22) Date of filing: 15.11.2018
(51) Int. Cl.: G02F 1/1516

(54) **COLLOIDAL COATING DISPERSION**
KOLLOIDALE BESCHICHTUNGSDISPERSION
DISPERSION DE REVÊTEMENT COLLOÏDALE

(43) Date of publication of application: 20.05.2020
(73) Proprietor: Fraunhofer-Gesellschaft zur Förderung der angewandten Forschung e.V., 80686 München (DE); Università degli Studi di Milano - Bicocca, 20126 Milano (IT)
(72) Inventor: Macher, Sven, 97070 Würzburg (DE); Posset, Uwe, 90556 Cadolzburg (DE); Beverina, Luca, 20159 Mailand (IT); Sassi, Mauro, 21040 Vedano Olona (IT); Schott, Marco, 97753 Karlstadt (DE)
(74) Representative: Pfenning, Meinig & Partner mbB

(56) References cited:
- US-A1- 2005 209 388
- US-A1- 2010 189 918
- Andreas Elschner ET AL: "ITO Alternative: solution deposited Clevios(TM)PEDOT:PSS for transparent conductive applications", , 6 June 2012 (2012-06-06), pages 1-11, XP055185017, Retrieved from the Internet: URL:http://www.heraeus-clevios.com/media/w ebmedia_local/media/datenblaetter/White_Pa per__ITO_Alternative__Solution_Deposited_C levios_PEDOT_PSS_materials_for_transparent _conductive_applications.pdf [retrieved on 2015-04-22]
- MACHER SVEN ET AL: "Avoiding Voltage-Induced Degradation in PET-ITO-Based Flexible Electrochromic Devices", APPLIED MATERIALS & INTERFACES, vol. 12, no. 32, 15 July 2020 (2020-07-15) , pages 36695-36705, XP055962538, US ISSN: 1944-8244, DOI: 10.1021/acsami.0c07860 Retrieved from the Internet: URL:https://pubs.acs.org/doi/pdf/10.1021/a csami.0c07860>
- Andreas Elschner ET AL: "ITO Alternative: solution deposited Clevios™PEDOT:PSS for transparent conductive applications", , 6 June 2012 (2012-06-06), pages 1-11, XP055185017, Retrieved from the Internet: URL:http://www.heraeus-clevios.com/media/w ebmedia_local/media/datenblaetter/White_Pa per__ITO_Alternative__Solution_Deposited_C levios_PEDOT_PSS_materials_for_transparent _conductive_applications.pdf [retrieved on 2015-04-22]
- Elschner Andreas ET AL: "PEDOT - Principles and Applications of an Intrinsically Conductive Polymer" In: "PEDOT - Principles and Applications of an Intrinsically Conductive Polymer", 1 January 2011 (2011-01-01), CRC Press, Taylor & Francis Group, XP055962543, ISBN: 978-1-4200-6911-2 pages 1-343, DOI: 10.1201/b10318,

## Description

The present invention relates to a colloidal coating dispersion comprising electrochromic polymer particles, a method for manufacturing the colloidal coating dispersion, the use of the colloidal coating dispersion for depositing at least one electrochromic layer on a substrate and an article comprising a layer deposited from the colloidal coating dispersion.

The manufacturing method according to the present invention allows manufacturing colloidal coating dispersions for depositing electrochromic polymer layers. With these colloidal dispersions of nanoparticles of conductive polymers electrochromic layers can be produced by a continuous roll-to-roll process. The colloidal coating dispersion is suitable for coatings on large-area, flexible film substrates. Due to favorable mechanical and optical properties, the resulting thin films can be used for smart shading applications in the architectural and automotive sectors. In addition, the colloid is suitable for printing processes (inkjet, etc.) after appropriate formulation.

This also opens up application possibilities in display (wearables, nearables), packaging and (interior) design areas. The process according to the invention combines a greatly simplified process with easy scalability and thus has great potential for cost savings. High costs have so far been the main obstacle to the wider use of smart shading systems beyond small series scale.

Coating dispersions based on polythiophenes are already known from the state of the art.

US 4,959,430 A refers to polythiophenes containing structural units of formula (I) in which A denotes an optionally substituted C1-C4-alkylene radical, their preparation by oxidative polymerization of the corresponding thiophenes and the use of the polythiophenes for imparting antistatic properties on substrates which only conduct electrical current poorly or not at all, in particular on plastic mouldings, and as electrode material for rechargeable batteries.

EP 0 440 957 A2 relates to dispersions of polythiophenes which are built up from structural units of the formula in which R1 and R2, independently of one another, are hydrogen or C1-C4-alkyl or together form an optionally substituted C1-C4-alkylene radical, in the presence of polyanions, to the preparation of these dispersions, and to their use for the antistatic finishing of plastic mouldings.

DE 10 2012 018 978 A1 describes processes for the production of a capacitor, comprising the process steps: a) the provision of an electrode body of an electrode material, wherein a dielectric covers one surface of this electrode material at least partly to form an anode body; b) the introduction of a dispersion comprising a dispersing agent and complexes of polythiophenes and polyanions, wherein the weight ratio of polythiophenes:polyanions in the dispersion is greater than 0.5, into at least a part of the anode body; c) the at least partial removal of the dispersing agent to obtain a solid electrolyte in a capacitor body. Also described are capacitors, electronic circuits, uses of these capacitors, processes for the preparation of dispersions, dispersions obtainable by these processes, organic solar cells, processes for the production of these organic solar cells, and the use of dispersion for the production of organic solar cells.

EP 2 831 183 A1 refers to a composite particle including a spheroidal core having a polymeric layer disposed thereon. In one embodiment, the polymeric layer includes a cationic surfactant and at least one of a nonionic polymer or an anionic polymer. In another embodiment, the polymeric layer includes a cationic polymer and an anionic polymer. Methods of making the composite particles, composite materials, and articles including them are also disclosed.

US 2016/064672 A1 refers to a method for fabricating a PEDOT:PSS-based electrode, comprising the steps of: preparing a PEDOT:PSS thin film formed on a substrate; treating the thin film with a solution containing 75-100 vol % of sulphuric acid or a sulphuric acid derivative; separating the thin film from the solution and rinsing the separated thin film; and drying the rinsed thin film at a temperature between 60°C and 160°C. A. Elschner et al. in "ITO Alternative: solution deposited Clevios™PEDOT:PSS for transparent conductive applications", Trade Article, Heraeus, 6.6.2012 and US 2005/0209388 disclose PEDOT derivatives I polyacid dispersions for forming conductive layers.

US 2013/270537 A1 describes a complex comprising a polythiophene and a sulphonated synthetic rubber. Also described is a process for producing complexes, the complexes obtained by this process, a composition, a layer structure, a process for producing the layer structure, the layer structure obtained by this process, electronic components, and the use of a composition.

DE 20 2012 007 001 U1 discloses a complex of poly (3,4-alkylenedioxythiophene) and polystyrene sulphonic acid, wherein the polystyrene sulphonic acid is a copolymer of styrene sulphonic acid and styrene and wherein for the degree of sulphation of the polystyrene sulphonic acid SGPSS: 50% >= SGPSS <80%.

DE 10 2013 004 526 A1 relates to a process for preparing a dispersion which comprises complexes of a polythiophene and a surfactant, wherein thiophene monomers are oxidatively polymerized in an aqueous phase in the presence of a surfactant by means of an organic peroxide. Also disclosed are dispersions obtainable by this process, a dispersion comprising complexes of a polythiophene and a surfactant, a process for producing an electrically conductive layer, by this obtainable electrically conductive layer and the use of the novel dispersions.

WO 2013/112777 A1 discloses a process for preparing a conductive polymer dispersion and a method for making capacitors using the conductive polymer. The process includes providing a monomer solution and shearing the monomer solution with a rotor-stator mixing system comprising a perforated stator screen having perforations thereby forming droplets of said monomer. The droplets of monomer are then polymerized during shearing to form the conductive polymer dispersion.

EP 2 438 120 A1 relates to an aqueous dispersion and a method for making an aqueous dispersion. The dispersion including at least one conductive polymer, such as a polythienothiophene, at least one hyperbranched polymer and optionally at least one colloid-forming polymeric acid and one non-fluorinated polymeric acid. Devices utilizing layers formed of the aqueous dispersions are also disclosed.

US 2005/224765 A1 refers to compositions, and methods of making nonaqueous dispersions of at least one doped conductive polymer and at least one colloid-forming polymeric acid, wherein the conductive polymer is selected from a polythiophene, a polypyrrole, a polyaniline, and combinations thereof. Electronic devices and other applications having at least one layer made from at least one of such compositions are further described.

US 2010/189918 A1 relates to a method for the preparation of a hybrid electrochromic coating material with superior performance in terms of transparency, electrochromic contrast, coloration efficiency, and adhesion, for a use in electrochromic devices for applications where a high transparency is required in the bleached state.

US 2014/226201 A1 refers to a flexible transparent electrochromic device, which includes the following components, each of which is a flexible film: a working electrode comprising a transparent conducting substrate supporting an working electrode active material; a counter electrode including a transparent conducting substrate supporting a counter electrode active material; a solid polymer electrolyte (SPE) including a solution of a lithium salt in a polymer solvent.

Starting herefrom, one object of the present invention is to avoid the known in-situ-polymerization processes for depositing layers of electrochromic polymers on a substrate and to allow depositing these layers by technically less demanding, less solvent consuming and more economic continuous roll-to-roll processes.

Another object of the present invention is to overcome the disadvantages of the coating dispersion for depositing electrochromic polymer layers known from the prior art and the provision of a colloidal coating dispersion based on at least one organic solvent as liquid phase allowing to use polymers based on water-insoluble monomers, preferably alcohol-soluble monomers, allowing to deposit thin films consisting solely of electronically conductive and electrochromic polymers, allowing to deposit layers that are free of water and thus lead to significantly higher stability in electrochemical cells, allowing to deposit a doped, electronically conductive and electrochromic colloid by wet-chemical standard processes on any substrate. Furthermore, it is one object of the present invention to provide a coating dispersion that can be prepared on a kilogram scale, that can be easily scaled up and that is stable for several months. An additional object of the present invention is the provision of a colloidal coating solution allowing a better film formation, having a homogenous, smooth surface and better wetting and adhesion properties compared to films deposited from aqueous dispersions or by in-situ oxidative polymerization.

This object is achieved by the colloidal coating dispersion according to claim 1 comprising electrochromic polymer particles having an average particle size *d*₅₀ in the range from 1 to 200 nm as solid phase and at least one alcohol as liquid phase; wherein the solids content of the colloidal coating dispersion is from 0.1 to 20 wt.-% based on the total mass of the colloidal coating dispersion; the electrochromic polymer particles are derived from a water-insoluble monomer selected from the group consisting of pyrrole derivatives, thiophene, thiophene derivatives or their mixtures; and the colloidal coating solution contains a maximum of 5 wt.-% of stabilizers and dispersing agents.

The dependent patent claims 2 to 6 relate to advantageous embodiments of the colloidal coating dispersion according to the invention.

In addition, a method for manufacturing a colloidal coating dispersion according to claims 1 to 6 is provided according to patent claim 7. The dependent claims 8 to 12 2 relate to preferred embodiments of the method according to the invention.

Furthermore, patent claim 13 relates to the use of the colloidal coating solution according to the invention for depositing at least one electrochromic layer on a substrate. The dependent claims 14 and 15 relate to advantageous embodiments according to said use.

### Average particle size, d₅₀ value

For the purpose of the present invention the "average particle size" is expressed by the "d₅₀ value". The *"d₅₀* value" means that 50 wt.-% of all particles are bigger than this particle size, whereas the remaining 50 wt.-% are smaller than this particle size. For the purpose of the present invention the particle size is specified as weight median particle size "*d*₅₀" unless indicated otherwise. For determining the "*d*₅₀ value" dynamic light scattering technology may be used. For determining the "*d*₅₀ value" of the polymer particles preferably a Zetasizer Nano ZS from Malvern Instruments GmbH is used.

### Absorption maximum and visual transmission hub

For the purpose of the present invention the absorption maximum is determined on the reduced ("dedoped" or neutral) polymer by UV-Visspectroscopy as described in the Experimental Section. The analysis is carried out on the reduced form of the polymer, due to the fact that the visible light absorption is maximally pronounced in this form. The reduction may be carried out as follows. A small sample is taken from the reaction mixture and transferred into n-heptanol in a separating funnel and washed three times with distilled water for removing the oxidant. After dilution with an alcohol a reducing agent is added for converting the polymer from an intermediate state in the completely reduced or neutral form.

Transmission spectra may be recorded on a AvaSpec-2048 Standard Fibre Optic Spectrometer with vaLight-DH-S-BAL Balanced deuterium-halogen lamp combination from Avantes. Photometric characteristics were calculated according to DIN EN 410.

### Layer adhesion

The layer adhesion may be determined according to DIN EN ISO 2409.

Where the term "comprising" is used in the present description and claims, it does not exclude other elements. For the purposes of the present invention, the term "consisting of" is considered to be a preferred embodiment of the term "comprising of". If hereinafter a group is defined to comprise at least a certain number of embodiments, this is also to be understood to disclose a group, which preferably consists only of these embodiments.

### Colloidal coating dispersion

According to a preferred embodiment of the present invention the average particle size *d*₅₀ of the electrochromic polymer particles is in the range from 10 to 200 nm, preferably from 10 to 100 nm and more preferably from 10 to 50 nm.

According to another preferred embodiment of the present invention, the solids content of the colloidal dispersion is from 0.5 to 10 wt.-%, preferably from 1 to 7.5 wt.-% and more preferably from 1 to 5 wt.-% based on the total mass of the colloidal coating dispersion.

A further preferred embodiment of the present invention provides that the average particle size *d*₅₀ of the electrochromic polymer particles is in the range from 10 to 200 nm, preferably from 10 to 100 nm and more preferably from 10 to 50 nm and the solids content of the colloidal dispersion is from 0.5 to 10 wt.-%, preferably from 1 to 7.5 wt.-% and more preferably from 1 to 5 wt.-% based on the total mass of the colloidal coating dispersion.

According to another preferred embodiment of the present invention the water-insoluble monomer is selected from the group consisting of poly(3-hexylthiophene-2,5-diyl), or sidechain-modified alkylene-3,4-dioxythiophenes, preferably ethylene-3,4-dioxythiophene or propylene-3,4-dioxythiophene or their mixtures, more preferably naphthalenediimide-functionalized ethylene-3,4-dioxythiophenes; or sidechain-modified alkylene-3,4-dioxythiophenes, preferably ethylene-3,4-dioxythiophene or propylene 3,4-dioxythiophenes or their mixtures obtained by subsequently performing the following steps:
a) reaction of a solution comprising a mixture of a compound having the general formula (I) and a compound having the general formula (II) in a molar ratio of (I) : (II) which is equal to m : (100-m) wherein m has a value in the range from 60 to 99 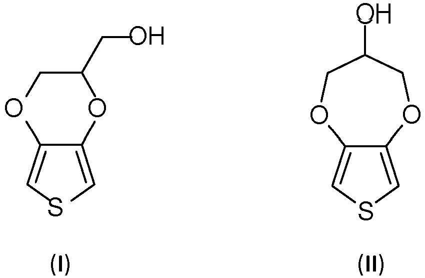
   with a compound of the general formula (III) 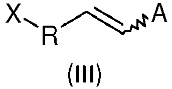
   wherein X is selected from the group consisting of Y-, Y-C(O),- OCN- or Y-CH₂C(O)O-
   in which Y is selected from the groups of halides, mesylates and or triflates,
   R is a linear and/or branched alkylene chain with 1 to 16 carbon atoms, and
   A is a linear and/or branched alkyl chain with 1 to 16 carbon atoms or hydrogen
b) optionally reacting the mixture of compounds derived from step a) by either
   b1) a vinyl copolymerization
   b2) a hydrosilylation of the vinyl moiety with a silane of the general formula HSiR'ᵤ(R")₃₋ᵤ, wherein
      R' is selected from the group consisting of linear or branched alkyl or alkenyl chains with 1 to 12 carbon atoms in the main-chain, wherein the chains can be substituted with acryloxy-, methacryloxy-, succinyl-, amino-, hydroxyl-, mercapto-, and/or glycidyloxy groups and/or interrupted by O- and/or S-atoms and/or a NR group, R" is selected from the group consisting of halogens, hydroxyl groups, alkoxy groups and/or acyl groups with 1 to 4 carbon atoms, and
      u = 0, 1, 2, 3; and further
   b3) a thiol-ene addition to the vinyl moiety with a compound of the general formula

      HS-R-SiR'ᵤ(R")₃₋ᵤ,

      wherein R, R', R" and u have the same meaning as indicated above;
c) chemical oxidative polymerization of a solution of the compound and/or the compounds derived from step b); and/or
naphthalenediimide-functionalized ethylene-3,4-dioxythiophenes.

More preferably the sidechain-modified ethylene-3,4-dioxythiophene comprises the units according to the following general formulae (IV) and (V) 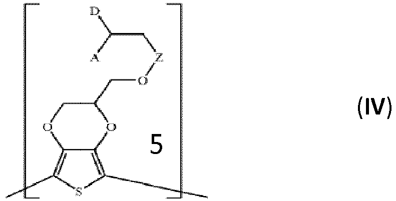 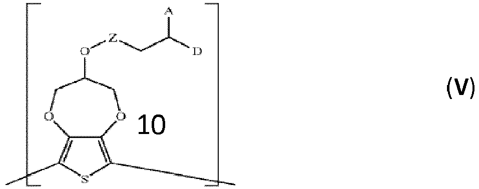
wherein Z is selected from the group consisting of the structural elements - R-, -C(O)-R-, -C(O)-NH-R- and -CH₂C(O)O-R-, wherein R is a linear and/or branched alkylene chain with 1 to 16 carbon atoms,
D is selected from the group consisting of H, -SiR'ᵤ(R")₃₋ᵤ, -S-R-SiR'ᵤ(R")₃₋ᵤ, and R has the same meaning as indicated above, preferably D = H,
R' is selected from the group consisting of linear or branched alkyl or alkenyl chains with 1 to 12 carbon atoms in the main chain, wherein the chains can be substituted with acryloxy-, methacryloxy-, succinyl-, amino-, hydroxyl-, mercapto-, and/or glycidyloxy groups and/or interrupted by O- and/or S-atoms and/or a NR'-group, wherein R' has the same meaning as indicated above,
R" is selected from the group consisting of halogens, hydroxyl groups, alkoxy groups and/or acyl groups with 1 to 4 carbon atoms, and u = 0, 1, 2, 3; or alternatively represents a chemical bonding to corresponding positions D of neighbored monomers of the formulae **(IV)** and/or **(V),**
A is a linear and/or branched alkyl chain with 1 to 16 carbon atoms or hydrogen, and
the compounds of the general formulae (IV) and (V) are comprised in a molar ratio of **(IV):(V)=** m/(100-m), wherein m has a value in the range from 1 to 99 and preferably from 60 to 99.

Particularly preferred sidechain-modified ethylene-3,4-dioxythiophene are summarized in the table below and their structure is shown below the table.

| **IUPAC-name** | **abbreviation** | **molecular formula** | **molecular weight [g/mol]** |
|---|---|---|---|
| 3,4-(2-(6-decenyloxy) propylene) dioxythiophene | EDOT-C10 | C₁₇H₂₆O₃S | 310,45 |
| 3,4-(2-(6-hexenyloxy) propylene) dioxythiophene | EDOT-C6 | C₁₃H₁₈O₃S | 254,35 |
| 3,4-(1-(hydroxypropylene) dioxythiopene | EDOT-MeOH | C₇H₈O₃S | 172,20 |
| 3,4-(2-(6-decenoate)propylene dioxythiophene | EDOT-C11 | C₁₈H₂₆O₄S | 338,46 |
| Naphthalenediimide-functionalized ethylene-3,4-dioxythiophene | EDOT-NTCl | C₄₂H₃₈O₁₆S₂N₂ | 890,89 |

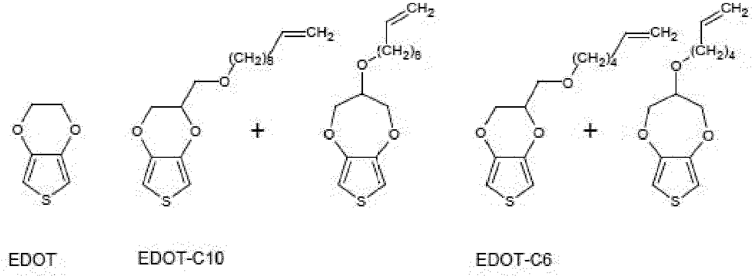

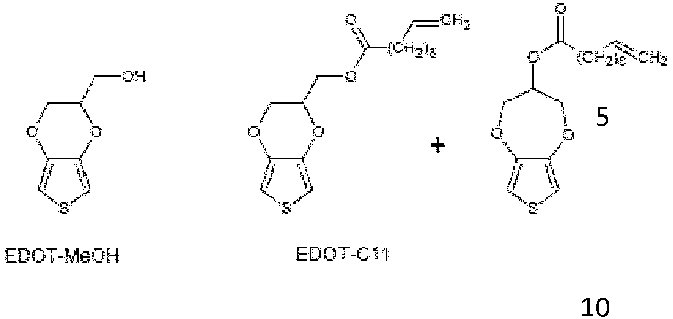

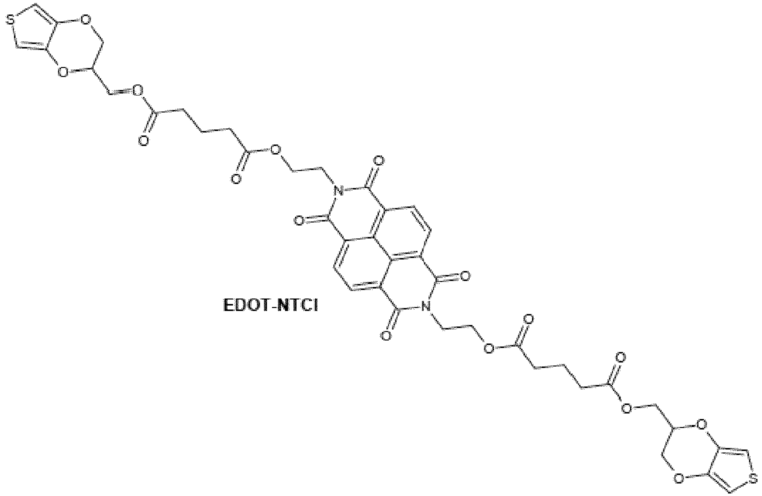

According to another preferred embodiment of the present invention the alcohol is preferably selected from the group consisting of ethanol, n-butanol, n-heptanol and mixtures thereof.

A further preferred embodiment of the present invention provides that the colloidal coating dispersion comprises additives. These additives are selected from the group consisting of
- non-polymeric binder materials, preferably SiO₂ or Indium-Tin oxide,
- surfactants, preferably stearates, dodecylbenzenesulphonates, sulphate esters, sulphonate esters, phosphate esters, ethoxylates (e.g. Triton X-100), fatty acid esters (e.g. Spans, Tweens), amines, amine oxides, Solsperse Hyperdispersants,
- polymeric binders, preferably inorganic-organic hybrid polymers, more preferably producable from a prepolymer (a) having groups, which are bonded to silicon via carbon, with organically crosslinkable or organically crosslinked moieties, more preferably (meth)acrylic groups, norbornenyl groups or epoxy groups, and/or wherein the crosslinkable organic monomer or a prepolymer (b) that contains at least one group per molecule that has one or more C=C double bonds, more preferably vinyl-, acrylate-, methacrylate groups, or at least one epoxy group; and mixtures thereof.

It is furthermore preferred that the additives are contained in 1 to 50 wt.-% based on the total mass of the colloidal coating dispersion.

The additives in the gist of present invention are added for improving film formation and improvement of the adhesive properties, but do not have a stabilizing or dispersing effect.

According to another preferred embodiment of the present invention after 12 months of storage of the colloidal coating dispersion no agglomeration, precipitation or phase separation is observed.

### Method for manufacturing a colloidal coating dispersion

The inventive method for manufacturing a colloidal coating dispersion as described above comprises the following steps:
(i) provision of at least one water-insoluble monomer;
(ii) provision of at least one alcohol;
(iii) solving the water-insoluble monomer from step (i) in the organic solvent from step (ii);
(iv) addition of at least one oxidizing agent before, during or after step (iii) to initiate the polymerization of the water-insoluble monomer;
(v) polymerizing the water-insoluble monomer;
(vi) removing the oxidizing agent added in step (iv) to stop the polymerization and to obtain a colloidal coating dispersion.

According to a preferred embodiment of the method according to the present invention the molar ratio between the at least one water-insoluble monomer provided in step (i) and the at least one alcohol provided in step (ii) is from 1 : 25 to 1 : 510, preferably from 1 : 255 to 1 : 510 and more preferably is 1 : 255 or 1:25.

Another preferred embodiment of the method according to the present invention provides that the molar ratio between the at least one oxidizing agent provided in step (iv) and the at least one water-insoluble monomer provided in step (i) is from 1 : 1.50 to 1 : 3.00, preferably from 1 : 1.75 to 1 : 2.5 and more preferably is 1 : 2.25.

According to another preferred embodiment of the present invention step (v) is carried out for a period of time from 1 to 72 h, preferably from 1 to 6 h and more preferably for 3 h in a temperature range from -12 to 25°C, most preferably step (v) is carried out until the absorption maximum of the reduced polymer is in the range from 350 to650 nm.

Below table summarizes the preferred absorption wavelength of some polymers as well as preferred ranges.

| **IUPAC-name** | **abbreviation** | **molecular formula** | **molecular weight [g/mol]** | **absorption wavelength [nm] of the polymer** |
|---|---|---|---|---|
| Poly(3-hexylthiophen | P3HT | (C₁₀H₁₄S)ₙ | 166.28n | 480±50 |
| Poly(3-decylpyrrole) | P3DP | (C₁₄H₂₄N)ₙ | 206.35n | 400±50 |
| 3,4-(1-(hydroxypropylene) dioxythiopene | EDOT-MeOH | C₇H₈O₃S | 172,20 | 600±50 |
| 3,4-(2-(6-decenoate)propylene dioxythiophene | EDOT-C11 | C₁₈H₂₆O₄S | 338,46 | 600±50 |
| Poly(3,4-(2-(6-hexenyloxy) propylene) dioxythiophene) | PEDOT-C6 | (C₁₃H₁₈O₃S)ₙ | 254.35n | 600±50 |
| 3,4-(2-(6-decenyloxy) propylene) dioxythiophene | EDOT-C10 | C₁₇H₂₆O₃S | 310,45 | 600±50 |
| Naphthalenediimide-functionalized poly(ethylene-3,4-dioxythiophene)^{a} | PEDOT-NTCl | (C₄₂H₃₈O₁₆S₂N₂)ₙ | 890.89n | 400±50 |
| | | | | 600±50 |

| | | | | |
|---|---|---|---|---|
| a) has two characteristic absorption bands. | | | | |

Another preferred embodiment of the method according to the present invention provides that the molar ratio between the at least one water-insoluble monomer provided in step (i) and the at least one alcohol provided in step (ii) is from 1 : 25 to 1 : 510, preferably from 1 : 255 to 1 : 510 and more preferably is 1 : 255 and that the molar ratio between the at least one oxidizing agent provided in step (iv) and the at least one water-insoluble monomer provided in step (i) is from 1 : 1.50 to 1 : 3.00, preferably from 1 : 1.75 to 1 : 2.5 and more preferably is 1 : 2.25 and that step (v) is carried out for a period of time from 1 to 72 h, preferably from 1 to 6 h and more preferably for 3 h in a temperature range from -12 to 25 °C, most preferably step (v) is carried out until the absorption maximum of the reduced polymer is in the range from 350 to 650 nm, preferably in the range from 380 to 650 and more preferably from 400 to 650 nm.

The water-insoluble monomer is preferably selected from the group consisting of poly(3-hexylthiophene), or sidechain-modified alkylene-3,4-dioxythiophenes, preferably ethylene-3,4-dioxythiophenes or propylene-3,4-dioxythiophenes and more preferably naphthalenediimide-functionalized alkylene-3,4-dioxythiophenes; or sidechain-modified alkylene-3,4-dioxythiophene as defined above in section "colloidal coating dispersion".

According to another preferred embodiment of the method of the present invention the alcohol is preferably selected from the group consisting of ethanol, n-butanol, n-heptanol and mixtures thereof.

Another preferred embodiment of the method according to the present invention provides that the oxidizing agent is selected from the group consisting of iron(III)-salts, preferably iron(III)-chloride, iron-(III)-sulphate, iron-(III)-perchlorate, iron(III) butylnaphthalenesulphonate, iron-(III)-alkylsulphonates, iron-(III)-carboxylate, iron(III) camphorsulphonate, iron-(III)-dodecylsulphonate, iron-(III)-salts of aromatic sulphonic acids, preferably iron-(III)-benzenesulphonate, iron(III) dodecylbenzenesulphonate, iron(III)-p-toluenesulphonates and/or mixtures thereof, hydrogenperoxide, dichromates, peroxydisulphates, perchlorates, persulphates, perborates, permanganates and/or mixtures thereof.

According to another preferred embodiment of the method of the present invention the water-insoluble monomer is preferably at least one sidechain-modified alkylene-3,4-dioxythiophene, more preferably at least one sidechain-modified alkylene-3,4-dioxythiophene as defined above and the alcohol is preferably selected from ethanol, n-butanol, n-heptanol and mixtures thereof and the oxidizing agent is selected from the group consisting of iron(III)-salts, preferably iron(III)-chloride, iron-(III)-sulphate, iron-(III)-perchlorate, iron(III) butylnaphthalenesulphonate, iron-(III)-alkylsulphonates, iron-(III)-carboxylate, iron(III) camphorsulphonate, iron-(III)-dodecylsulphonate, iron-(III)-salts of aromatic sulphonic acids, preferably iron-(III)-benzenesulphonate, iron(III) dodecylbenzenesulphonate, iron(III)-p-toluenesulphonates and/or mixtures thereof, hydrogenperoxide, dichromates, peroxidisulphates, perchlorates, persulphates, perborates, permanganates and/or mixtures thereof.

Another preferred embodiment of the method according to the present invention provides that step (vi) is carried out by diluting the mixture with an organic solvent, preferably n-heptanol, and stirring this mixture, addition of water to obtain an aqueous phase and an organic phase, and separation of the aqueous phase containing the oxidizing agent, more preferably the sequence: addition of water and separating the aqueous phase is repeated at least three times.

According to another preferred embodiment of the method of the present invention after step (vi) at least one alcohol is preferably n-butanol, is added to adjust the solids content in the range from 0.1 to 20 wt.-% and preferably from 1 to 20 wt.-% based on the total weight of the colloidal coating dispersion, preferably the colloidal coating dispersion is stirred vigorously after addition of the alcohol and subsequently agglomerates having an average particle size > 5 µm are removed by filtration.

According to another preferred embodiment of the method of the present invention additives are added before, after or during step (v). These additives are preferably selected from the group consisting of non-polymeric binder materials, surfactants, polymeric binders, inorganic-organic hybrid polymers and mixtures thereof, more preferably the additives are contained in 1 to 50 wt.-% based on the total mass of the colloidal coating dispersion.

According to a further preferred embodiment of the method of the present invention the alcohol provided in step (ii) is n-butanol or steps (ii) to (v) are conducted in a temperature range from 15 to 25°C or step (v) is conducted over a period of time from 60 to 80 hours.

According to another preferred embodiment of the method of the present invention the alcohol provided in step (ii) is n-butanol and steps (ii) to (v) are conducted in a temperature range from 15 to 25°C and step (v) is conducted over a period of time from 60 to 80 hours. By applying these conditions the absorption maximum of the reduced polymer is in the range from 350 to 650 nm.

### Use of the colloidal coating solution

Another aspect of the present invention relates to the use of the colloidal coating solution as described above for depositing at least one electrochromic layer on a substrate.

According to one preferred embodiment of the use of present invention the deposition is conducted by spin coating, slot-die coating or printing processes. Another preferred embodiment of the use according to the present invention provides that the substrate is selected from the group consisting of
- Transparent conducting plastic films, more preferably polyesters such as polyethylene terephthalate, coated with a transparent conducting oxide selected from the group consisting of tin-doped indium oxide, fluorine-doped tin oxide, aluminium-doped zinc oxide, aluminium-doped zirconium oxide, antimony-doped tin oxide, antimony/tin-doped zinc oxide, indium/tin-doped zinc oxide, and/or mixtures thereof,
- Glass coated with a transparent conducting oxide selected from the group given above,
- Metal (mirrors) selected from the group Al, Ni, Ag, Au, Pd, Pt, Cu and alloys thereof, coated with a transparent conducting oxide selected from the group given above,
- Textiles and fabrics comprising conductive components, e.g. metal wires, or a conducting oxide selected from the group given above,
- Plastic film, glass, metal, and fabrics coated with an intrinsically conducting polymer such as PEDOT:PSS and combinations.
- Plastic film, glass, metal, and fabrics coated with a transparent conducting oxide selected from the group given above and an intrinsically conducting polymer such as PEDOT:PSS and combinations. Plastic film, glass and metal coated with a transparent layer stack comprising insulator/metal/insulator, semiconductor/metal/insulator or semi-conductor/metal/semiconductor or multiples thereof.
- Plastic film, glass and metal optionally over- or under-coated with a metal mesh or grid, an optionally over- or undercoated metal or carbon nanowire deposit, carbon nanotubes, graphene and mixtures thereof.

Another preferred embodiment of the use according to the present invention provides that the deposited layer is used in an application selected from the group consisting of electrochromic devices, an electron acceptor (or hole conductor) layer for organic photovoltaics, a conductive finishing of surfaces and fabrics, an active layer of a battery component/electrode, a hole conductor layer in OLEDs, a cathode layer or deposit in electrolytic capacitors or a layer or deposit in a sensor.

### Article comprising at least one layer deposited from the colloidal coating solution

Another aspect not part of the claimed invention relates to an article comprising at least one layer deposited from the colloidal coating solution as defined above.

According to a preferred embodiment of the article the deposited layer consists of at least one electrochromic polymer.

Another preferred embodiment of the provides that the layer adhesion determined according to DIN EN ISO 2409 is rated with GT0.

According to another preferred embodiment of the article the visual transmission hub determined according to DIN EN 410 is in the range from 55 to 60 %.

### Description of the Figures

Figures 1 and 2 show the results of (in-situ) spectro-electrochemical measurements of the layer obtained from a dispersion according to Working Examples 1 and 2. Figure 3 shows UV-Vis-NIR spectra measured during the polymerization according to Working Example 2.

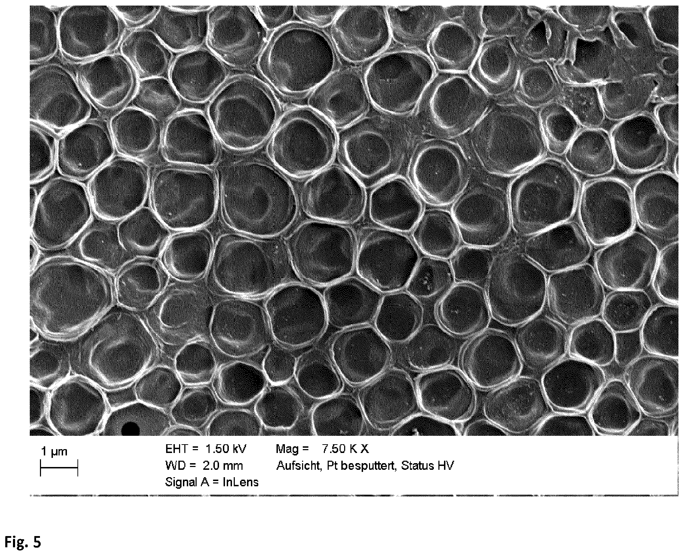

Figures 4 to 6 show scanning electron microscopy images (field emission scanning electron microscope Ultra 55 from Carls Zeiss NTS GmbH) of electrochromic polymer layers.

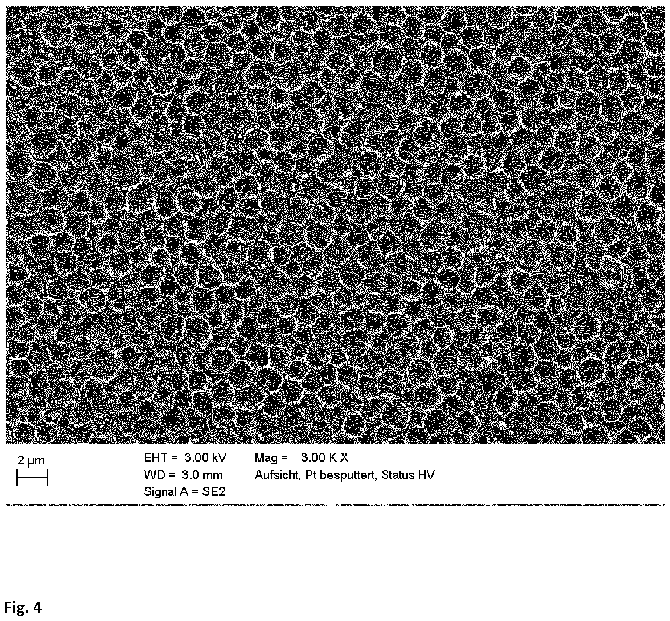

Figures 4 (magnification: 3.00 KX) and 5 (magnification: 7.50 KX) show layers obtained by in-situ polymerization of the electrochromic polymer on the surface of a substrate, respectively. An alveolar surface structure is observed.

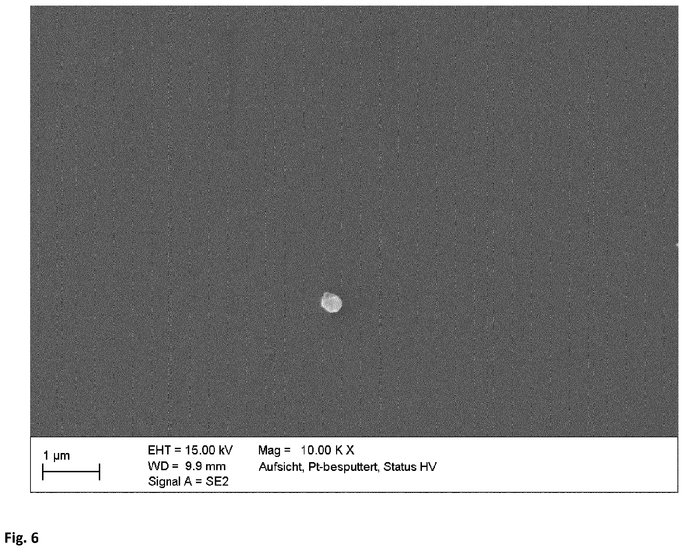

Figure 6 (magnification: 10.00 KX) shows a layer deposited from a colloidal coating dispersion according to the present invention. As can be gathered from this figure the surface is homogenous and smooth.

The subject according to the invention is intended to be explained in more detail with reference to the subsequent examples without wishing to restrict said subject to the specific embodiments shown here.

### 1 Measuring Methods

Within the scope of this application, the following measuring methods have been used.

### UV-Vis-NIR-spectroscopy

The UV-Vis-NIR spectra were measured on a digital CCD Avantes Ava-Spec-2048 Standard Fiber Optic Spectrometer of the company Avantes. The light source used was a deuterium-halogen lamp combination from Avantes (wave length from 200 nm to 2500 nm). The optical contribution of the substrate was taken into account by a reference measurement. The measurements were carried out at room temperature. The sample was arranged so that first the electrochromic layer and subsequently the substrate were irradiated.

### (In-situ) spectroelectrochemical measurements

The in-situ spectro-electrochemical measurements were also carried out with the AvaSpec-2048 Standard Fiber Optic Spectrometer from Avantes. For this purpose, the sample of the electrochromic layer to be analyzed was first arranged on a PET-ITO film (working electrode) and then installed in a special glass cuvette made for the Fraunhofer Institute for Silicate Research ISC. The area of the sample was 1.7 × 3.0 cm². For better contacting, the conductive side of the sample was glued to the uncoated edge with a copper tape commercially available from 3M. The counterelectrode used consists of platinum and the electrolyte used was 1 M lithium perchlorate in propylene carbonate. The required switching voltage was generated with a Voltcraft PS 1152A laboratory power supply.

### REM-EDX

The polymer layers were examined in terms of topology and composition using a field emission scanning electron microscope Ultra 55 from the company Carl Zeiss NTS GmbH under high vacuum. Acceleration voltage, working distance and magnification are each given together with the corresponding images. The samples to be examined were sputtered with platinum on the sputtering unit MED 010 from Oerlikon Balzers Coating AG.

### Layer adhesion

The adhesion quality of the electrochromic polymer layers on the PET-ITO substrate was determined by means of the cross-cut and tape test in accordance with DIN EN ISO 2409. For this purpose, 6 horizontal and 6 vertical sections were cut into the layer at a distance of 1 mm using a cutter knife and a template. Subsequently, an adhesive tape was applied to the cutting grid and pulled off after a waiting time of 1 minute.

### Particle size

To measure the particle size distribution of the dispersions, the method of dynamic light scattering was used. The measurement was carried out on the Zetasizer Nano ZS of Malvern Instruments GmbH using a red helium-neon laser emitting at a wavelength of 633 nm. Ethanol was used as the dispersing medium.

### 2 Starting Materials

The materials used for manufacturing the colloidal coating dispersion according to the invention are compiled in table 1.

**Table 1**

| **Components** | **Manufacturer** |
|---|---|
| n-butanol | Sigma Aldrich |
| iron(III)-tosylate | Heraeus |
| n-heptanol | Sigma Aldrich |
| hydrochloric acid | Merck |

Furthermore, the mixture EDOT-C6 as shown below has been used as monomer.

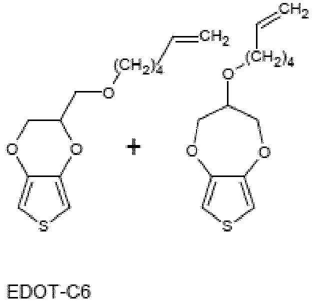

The monomer mixture EDOT-C6 (ratio of EDOT:ProDOT isomer = 99:1) has been prepared according to the conditions and methods disclosed in WO 2008/064878 A1.

### 3 Examples

### Example 1 (inventive)

Example 1 was carried out in a round flask equipped with a magnetic stirring bar. First, the solvent n-butanol (5 mol) was added to the round flask and then the monomer mixture EDOT-C6 (1 mol) was added at 25°C under stirring to obtain a yellowish, but transparent solution. Subsequently, the solution has been stirred for further 10 minutes at 300 rpm. Then the oxidizing agent iron(III)-tosylate (1.75 mol solved in 20 mol n-BuOH) was added under stirring. The resulting yellow-orange mixture has been stirred and polymerized at 25°C for 72 hours. Afterwards, the polymerization was stopped by solvent extraction. For that purpose the reaction mixture was added into n-heptanol (6.5 mol) and the solvent extraction was conducted in a separating funnel using distilled water acidified with 1 molar hydrochlorid acid (pH 2-3, 5 times the volume of the organic phase) as aqueous phase. For entirely removing the oxidizing agent from the organic phase the solvent extraction process was repeated three times with the same amount of the acidified aqueous phase. The obtained deep blue dispersion (organic phase) was filtered via a syringe filter (5 µm). Finally, the solid content of the dispersion was adjusted to 7.5 wt.-% by addition of n-butanol (30 mol).

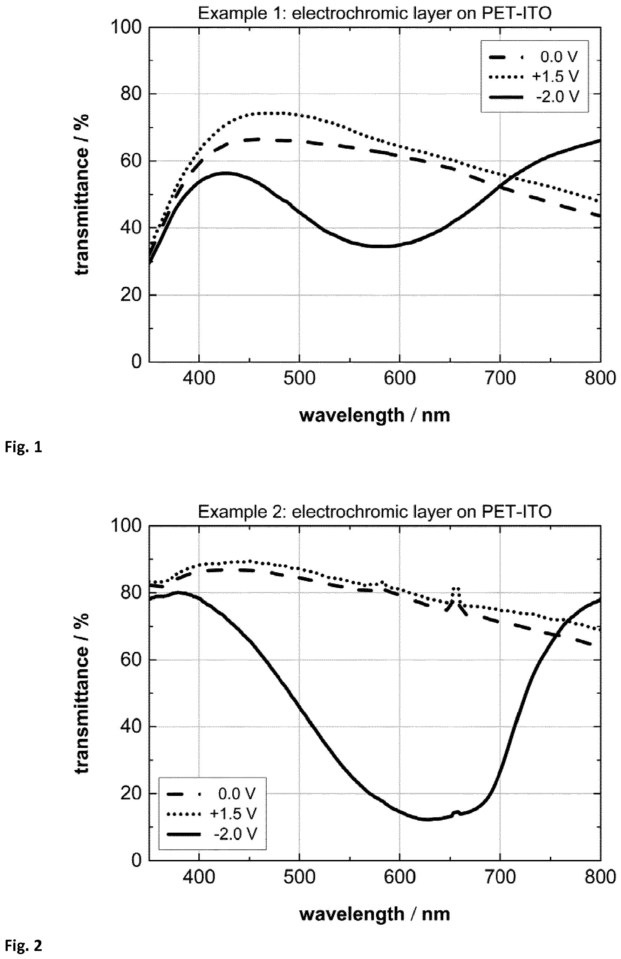

The dispersion produced this way shows high stability of several months (at least 24 months). Therefore, no stability-improving surfactants or other additives need to be added. A binder material may be added if the subsequent coating process requires it. Likewise, the solids content, initially at 7.5%, can be reduced by adding more n-butanol. This results - in contrast to the effect of a binder additive - in a reduction of the viscosity of the coating solution. Even without a binder, the inventive coating exhibits excellent adhesion to electronically conductive plastic substrates (e.g. PET-ITO) and a temperature stability that generally exceeds that of the substrates. Figure 1 shows the results of the (in situ) spectro-electrochemical measurements of the layers resulting from the colloidal coating dispersion according to Example 1. These measurements represent the most important properties of an electrochromic layer. The visual transmission hub for the obtained layer is 31% and has been calculated according to DIN EN 410.

### Example 2 (not according to the invention)

Example 2 was conducted in a double-walled reaction vessel equipped with a thermometer and a mechanical stirrer (crescent-shaped). The oxidizing agent iron(III)-tosylate (2.25 mol) was added to a laboratory bottle, acetonitrile (255 mol) and distilled water (13.7 mol) were added as solvents. Under stirring by using a magnetic stirrer the oxidizing agent was solved in the solvents at 25°C. EDOT-C6 (1 mol) was added under stirring (300 rpm) at 25°C. In the meantime the double-walled reaction vessel was cooled to -8°C by using a cryostat. The resulting solution containing the solvents, the oxidizing agent and the monomer was added to the cooled doubled-walled reaction vesseland the polymerization was conducted for 3 hours at that temperature. Afterwards, the polymerization was stopped by solvent extraction. For that purpose the reaction mixture was added into n-heptanol (15 mol) and the solvent extraction was conducted in a separating funnel using distilled water, acidified with 1 molar hydrochloric acid (pH 2-3, 5 times the volume of the organic phase) as aqueous phase. For entirely removing the oxidizing agent from the organic phase the solvent extraction process was repeated three times with the same amount of the acidified aqueous phase. The obtained deep blue dispersion (organic phase) was filtered via a syringe filter (5 µm). Finally, the solid content of the dispersion was adjusted to 7.5 wt. % by addition of n-butanol (30 mol).

The dispersion prepared this way shows high storage stability. Figure 2 shows the results of the (in situ) spectro-electrochemical measurements of the layers resulting from the colloidal coating dispersion according to Example 2. These measurements represent the most important properties of an electrochromic layer. The visual transmission hub for the obtained layer is 57% and has been calculated according to DIN EN 410.

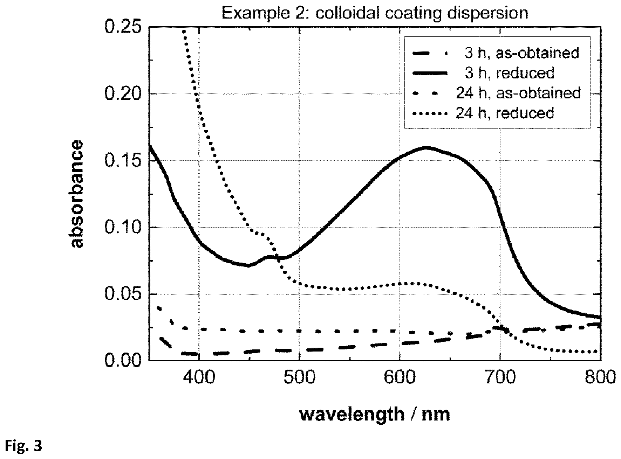

Figure 3 shows the development of the UV-Vis spectra as a function of the polymerization time. The spectra were recorded on a highly diluted colloidal coating dispersion. Surprisingly, no longer polymer chains are achieved by a longer polymerization time (bathochromic shift of the absorption band). On the contrary, an optimum results at a polymerization time of 3 h.

### Deposition of electrochromic layers

Electrochromic layers were deposited from the dispersion obtained from Examples 1 and 2 within the scope of pilot plant trials on a fully automatic roll-to-roll coating plant. The substrate - a polyethylene terephthalate coated with tin-doped indium oxide - was subjected to corona pretreatment (1.00 kW). By using a slot-die with a 50 µm shim, wet films of various thicknesses were applied to the substrate. For this purpose, the slot-die is filled with an Oerlikon Barmag gear pump (type: 1-012-8055). The wet film thickness can be controlled via the pump frequency and the web speed. The pump frequency is in the range of 5 to 60 Hz and the web speed in the range between 0.1 and 1.0 m/min. After application of the coating dispersion the wet film is dried in four oven modules (2 × 100 °C., 2 × 120 °C.), wherein the drying temperature can be varied between 80 and 140 °C. A wet film thickness of 18 µm has been obtained by applying a web speed of 0.5 m/min and a pump frequency of 18 Hz.

As can be gathered from the table below, the optical properties and the layer adhesion for a substrate coated from a colloidal dispersion not according to the present invention and coated by in-situ polymerization are almost the same. However, the colloidal coating dispersion according to the present invention allows not only to deposit layers by well-scalable and straightforward standard processes, but additionally allows to obtain smooth and homogenous layers that will not produce substantial haze (diffuse light scattering). Further the present invention is to avoid the in-situ-polymerization processes for depositing layers of pure electrochromic polymers on a substrate leading to a technically less demanding, less solvent consuming and more economic coating process.

| | **Comparative Example 1^{a}** | **Example 2^{b}** |
|---|---|---|
| Transmission hub (625 nm) [%] | 61 | 66 |
| Layer adhesion | GT0 | GT0 |

| | | |
|---|---|---|
| *a) Comparative Example 1 corresponds to Example 1d on page 11 and Example 2d starting on page 14 of* EP 2 570 846 A1*.* *^{b)} not according to the invention* | | |

## Claims

1. Colloidal coating dispersion comprising electrochromic polymer particles having an average particle size *d*₅₀ in the range from 1 to 200 nm as solid phase and at least one alcohol as liquid phase; wherein
the solids content of the colloidal coating dispersion is from 0.1 to 20 wt.-% based on the total mass of the colloidal coating dispersion; the electrochromic polymer particles are derived from a water-insoluble monomer selected from the group consisting of pyrrole derivatives, thiophene, thiophene derivatives or their mixtures; and the colloidal coating solution contains a maximum of 5 wt.-% of stabilizers and dispersing agents.

2. Colloidal coating dispersion according to claim 1, **characterized in that**,
the average particle size *d*₅₀ of the electrochromic polymer particles is in the range from 10 to 200 nm, preferably from 10 to 100 nm and more preferably from 10 to 50 nm; and/or
the solids content of the colloidal dispersion is from 0.5 to 10 wt.-%, preferably from 1 to 7.5 wt.-% and more preferably from 1 to 5 wt.-% based on the total mass of the colloidal coating dispersion.

3. Colloidal coating dispersion according to claim 1 or 2, **characterized in that**,
the water-insoluble monomer is selected from the group consisting of poly(3-hexylthiophene), or sidechain-modified alkylene-3,4-dioxythiophenes, preferably ethylene-3,4-dioxythiophene or propylene-3,4-dioxythiophene or their mixtures, more preferably naphthalenediimide-functionalized ethylene-3,4-dioxythiophenes; or sidechain-modified alkylene-3,4-dioxythiophene, preferably ethylene-3,4-dioxythiophene, propylene-3,4-dioxythiophene or their mixtures.

4. Colloidal coating dispersion according to claim 3, **characterized in that**,
the sidechain-modified alkylene-3,4-dioxythiophene comprises the units according to the following general formulae (IV) and (V) 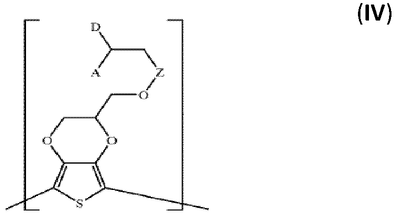 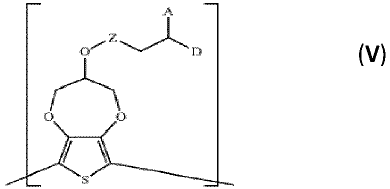
wherein
Z is selected from the group consisting of the structural elements - R-, -C(O)-R- and -C(O)-NH-R-, -CH₂-C(O)O-R-, wherein R is a linear and/or branched alkylene chain with 1 to 16 carbon atoms,
D is selected from the group consisting of H, -SiR'ᵤ(R")₃₋ᵤ, -S-R-SiR'ᵤ(R")₃₋ᵤ, and R has the same meaning as indicated above, preferably D = H,
R' is selected from the group consisting of linear or branched alkyl or alkenyl chains with 1 to 12 carbon atoms in the main chain, wherein the chains can be substituted with acryloxy-, methacryloxy-, succinyl-, amino-, hydroxyl-, mercapto-, and/or glycidyloxy groups and/or interrupted by O- and/or S-atoms and/or a NR' group, wherein R' has the same meaning as indicated above,
R" is selected from the group consisting of halogens, hydroxyl groups, alkoxy groups and/or acyl groups with 1 to 4 carbon atoms, and u = 0, 1, 2, 3; or alternatively represents a chemical bonding to corresponding positions D of neighbored monomers of the formulae (IV) and/or (V),
A is a linear and/or branched alkyl chain with 1 to 16 carbon atoms or hydrogen, and
the compounds of the general formulae (IV) and (V) are comprised in a molar ratio of (IV):(V)= m/(100-m), wherein m has a value in the range from 1 to 99 and preferably from 60 to 99.

5. Colloidal coating dispersion according to any one of claims 1 to 3, **characterized in that**,
the colloidal coating dispersion comprises additives, preferably selected from the group consisting of
• non-polymeric binder materials, preferably SiO₂ or Indium-Tin oxide,
• surfactants, preferably stearates, dodecylbenzenesulphonates, sulphate esters, sulphonate esters, phosphate esters, ethoxylates, fatty acid esters, amines, amine oxides,
• polymeric binders, preferably inorganic-organic hybrid polymers, more preferably producable from a prepolymer (a) having groups, which are bonded to silicon via carbon, with organically crosslinkable or organically crosslinked moieties, more preferably (meth)acrylic groups, norbornenyl groups or epoxy groups, and/or wherein the crosslinkable organic monomer or prepolymer (b) contains at least one group per molecule that has one or more C=C double bonds, more preferably vinyl-, acrylate-, methacrylate groups, or at least one epoxy group; and mixtures thereof,
more preferably the additives are contained in 1 to 50 wt.-% based on the total mass of the colloidal coating dispersion.

6. Method for manufacturing the colloidal coating dispersion according to any one of claims 1 to 5, comprising the following steps:
(i) provision of at least one water-insoluble monomer selected from the group consisting of pyrrole derivatives, thiophene, thiophene derivatives or their mixtures;
(ii) provision of at least one alcohol;
(iii) solving the water-insoluble monomer from step (i) in the alcohol from step (ii);
(iv) addition of at least one oxidizing agent before, during or after step (iii) to initiate the polymerization of the water-insoluble monomer;
(v) polymerizing the water-insoluble monomer;
(vi) removing the oxidizing agent added in step (iv) to stop the polymerization and to obtain a colloidal coating dispersion,
wherein step (vi) is carried out by diluting the mixture with an organic solvent and stirring this mixture, addition of water to obtain an aqueous phase and an organic phase, and separation of the aqueous phase containing the oxidizing agent.

7. Method according to claim 6, **characterized in that**,
the molar ratio between the at least one water-insoluble monomer provided in step (i) and the at least one alcohol provided in step (ii) is from 1: 25 to 1 : 510, preferably from 1 : 255 to 1 : 510 and more preferably is 1 : 255 or 1:25; and/or
the molar ratio between the at least one oxidizing agent provided in step (iv) and the at least one water-insoluble monomer provided in step (i) is from 1 : 1.50 to 1 : 3.00, preferably from 1 : 1.75 to 1 : 2.5 and more preferably is 1 : 2.25; and/or
step (v) is carried out for a period of time from 1 to 72 h, preferably from 1 to 6 h and more preferably for 3 h in a temperature range from -12 to 25 °C, most preferably step (v) is carried out until the absorption maximum of the reduced polymer is in the range from 350 to 650 nm, more preferably in the range from 380 to 650 nm and most preferably in the range from 400 to 650 nm.

8. Method according to claim 6 or 7, **characterized in that**,
the water-insoluble monomer is selected from the group consisting of poly(3-hexylthiophene), or sidechain-modified alkylene-3,4-dioxythiophenes, preferably naphthalenediimide-functionalized alkylene-3,4-dioxythiophenes; or sidechain-modified alkylene-3,4-dioxythiophene and mixtures thereof; and/or
the alcohol is selected from the group consisting of ethanol, n-butanol, n-heptanol and mixtures thereof; and/or
one or more additional organic solvent(s) is(are) optionally used;
and/or
the oxidizing agent is selected from the group consisting of iron(III)-salts, preferably iron(III)-chloride, iron-(III)-sulphate, iron-(III)-perchlorate, iron(III) butylnaphthaenesulphonate, iron-(III)-alkylsulphonates, iron-(III)-carboxylate, iron(III) camphorsulphonate, iron-(III)-dodecyl-sulphonate, iron-(III)-salts of aromatic sulphonic acids, preferably iron-(III)-benzenesulphonate, iron(III) dodecylbenzenesulphonate, iron(III)-p-toluenesulphonates and/or mixtures thereof, hydrogenperoxide, dichromates, peroxydisulphates, perchlorates, persulphates, perborates, permanganates and/or mixtures thereof.

9. Method according to any one of claims 6 to 8, **characterized in that**,
step (vi) is carried out by diluting the mixture with an organic solvent, preferably n-heptanol and stirring this mixture, addition of water to obtain an aqueous phase and an organic phase, and separation of the aqueous phase containing the oxidizing agent, the sequence: addition of water and separating the aqueous phase is repeated at least three times.

10. Method according to claim 9, **characterized in that**,
after step (vi) at least one alcohol, preferably n-butanol, is added to adjust the solids content in the range from 0.1 to 20 wt.-% and preferably from 1 to 20 wt.-% based on the total weight of the colloidal coating dispersion, preferably the colloidal coating dispersion is stirred vigorously after addition of the at least one alcohol and subsequently agglomerates having an average particle size > 5 µm are removed by filtration.

11. Method according to any one of claims 6 to 10, **characterized in that**,
steps (ii) to (v) are conducted in a temperature range from -5 to -15°C, and/or step (v) is conducted over a period of time from 1.5 to 4.5 hours; or
the organic solvent provided in step (ii) is preferably n-butanol, and/or steps (ii) to (v) are conducted in a temperature range from 15 to 25°C, and/or step (v) is conducted over a period of time from 60 to 80 hours.

12. Method according to any one of claims 6 to 11, **characterized in that**,
additives are added before, after or during step (v), these additives are preferably selected from the group consisting of non-polymeric binder materials, surfactants, polymeric binders, inorganic-organic hybrid polymers and mixtures thereof, more preferably the additives are contained in 1 to 50 wt.-% based on the total mass of the colloidal coating dispersion.

13. Use of the colloidal coating solution according to claims 1 to 5 for depositing at least one electrochromic layer on a substrate.

14. Use according to claim 13, **characterized in that**,
the deposition is conducted by spin coating, slot-die coating or printing processes; and/or
the substrate is selected from the group consisting of
• Transparent conducting plastic films, more preferably polyesters such as polyethylene terephthalate, coated with a transparent conducting oxide selected from the group consisting of tin-doped indium oxide, fluorine-doped tin oxide, aluminium-doped zinc oxide, aluminium-doped zirconium oxide, antimony-doped tin oxide, antimony/tin-doped zinc oxide, indium/tin-doped zinc oxide, and/or mixtures thereof,
• Glass coated with a transparent conducting oxide selected from the group consisting of tin-doped indium oxide, fluorine-doped tin oxide, aluminium-doped zinc oxide, aluminium-doped zirconium oxide, antimony-doped tin oxide, antimony/tin-doped zinc oxide, indium/tin-doped zinc oxide, and/or mixtures thereof,
• Metal, preferably mirrors selected from the group Al, Ni, Ag, Au, Pd, Pt, Cu and alloys thereof, optionally coated with a transparent conducting oxide selected from the group consisting of tin-doped indium oxide, fluorine-doped tin oxide, aluminium-doped zinc oxide, aluminium-doped zirconium oxide, antimony-doped tin oxide, antimony/tin-doped zinc oxide, indium/tin-doped zinc oxide, and/or mixtures thereof,
• Textiles and fabrics comprising conductive components, preferably metal wires, or a conducting oxide selected from the group consisting of tin-doped indium oxide, fluorine-doped tin oxide, aluminium-doped zinc oxide, aluminium-doped zirconium oxide, antimony-doped tin oxide, antimony/tin-doped zinc oxide, indium/tin-doped zinc oxide, and/or mixtures thereof,
• Plastic film, glass, metal, and fabrics coated with an intrinsically conducting polymer, preferably PEDOT:PSS and combinations thereof;
• Plastic film, glass, metal, and fabrics coated with a transparent conducting oxide selected from the group consisting of tin-doped indium oxide, fluorine-doped tin oxide, aluminium-doped zinc oxide, aluminium-doped zirconium oxide, antimony-doped tin oxide, antimony/tin-doped zinc oxide, indium/tin-doped zinc oxide, and/or mixtures thereof and an intrinsically conducting polymer, preferably PEDOT:PSS and combinations thereof,;
• Plastic film, glass, metal, and fabrics coated with a transparent layer stack comprising insulator/metal/insulator, semi-conductor/metal/insulator or semi-conductor/metal/semi-conductor layers or multiples thereof, an optionally over- or under-coated metal mesh or grid, an optionally over- or undercoated metal or carbon nanowire deposit, carbon nanotubes, graphene and mixtures thereof.

15. Use according to claim 13 or 14, **characterized in that**,
the deposited layer is used in an application selected from the group consisting of electrochromic devices, an electron acceptor layer or hole conductor layer for organic photovoltaics, a conductive finishing of surfaces and fabrics, an active layer of a battery component/electrode, a hole conductor layer in OLED's, a cathode layer or deposit in electrolytic capacitors or a deposit layer in a sensor.

## Patentansprüche

1. Kolloidale Beschichtungsdispersion, enthaltend elektrochrome Polymerteilchen mit einer durchschnittlichen Teilchengröße dso im Bereich von 1 bis 200 nm als Feststoffphase und mindestens einen Alkohol als Flüssigphase; wobei
der Feststoffgehalt der kolloidalen Beschichtungsdispersion 0,1 bis 20 Gew.-%, bezogen auf die Gesamtmasse der kolloidalen Beschichtungsdispersion, beträgt; die elektrochromen Polymerteilchen von einem wasserunlöslichen Monomer, ausgewählt aus der Gruppe bestehend aus Pyrrolderivaten, Thiophen, Thiophenderivaten oder deren Mischungen, abgeleitet sind; und die kolloidale Beschichtungslösung maximal 5 Gew.-% Stabilisatoren und Dispergiermittel enthält.

2. Kolloidale Beschichtungsdispersion nach Anspruch 1, **dadurch gekennzeichnet, dass**,
die durchschnittliche Teilchengröße d₅₀ der elektrochromen Polymerteilchen im Bereich von 10 bis 200 nm, bevorzugt von 10 bis 100 nm und besonders bevorzugt von 10 bis 50 nm liegt; und/oder
der Feststoffgehalt der kolloidalen Dispersion 0,5 bis 10 Gew.-%, bevorzugt 1 bis 7,5 Gew.-% und besonders bevorzugt 1 bis 5 Gew.-%, bezogen auf die Gesamtmasse der kolloidalen Beschichtungsdispersion, beträgt.

3. Kolloidale Beschichtungsdispersion nach Anspruch 1 oder 2, **dadurch gekennzeichnet, dass**,
das wasserunlösliche Monomer ausgewählt ist aus der Gruppe bestehend aus Poly(3-hexylthiophen) oder seitenkettenmodifizierten Alkylen-3,4-dioxythiophenen, vorzugsweise Ethylen-3,4-dioxythiophen oder Propylen-3,4-dioxythiophen oder deren Mischungen, besonders bevorzugt Naphthalindiimid-funktionalisierte Ethylen-3,4-dioxythiophene; oder seitenkettenmodifiziertes Alkylen-3,4-dioxythiophen, vorzugsweise Ethylen-3,4-dioxythiophen, Propylen-3,4-dioxythiophen oder deren Mischungen.

4. Kolloidale Beschichtungsdispersion nach Anspruch 3, **dadurch gekennzeichnet, dass**,
das seitenkettenmodifizierte Alkylen-3,4-dioxythiophen die Einheiten gemäß den folgenden allgemeinen Formeln (IV) und (V) enthält, 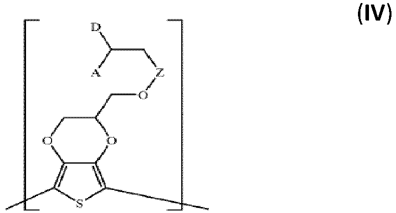 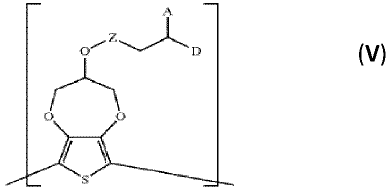
wobei
Z ausgewählt ist aus der Gruppe bestehend aus den Strukturelementen -R-, -C(O)-R- und -C(O)-NH-R-, -CH₂-C(O)O-R-, wobei R eine lineare und/oder verzweigte Alkylenkette mit 1 bis 16 Kohlenstoffatomen ist, D ausgewählt ist aus der Gruppe bestehend aus H, SiR'ᵤ(R")₃₋ᵤ, -S-R-SiR'ᵤ(R")₃₋ᵤ, und R die gleiche Bedeutung wie oben angegeben hat, vorzugsweise D=H,
R' ausgewählt ist aus der Gruppe bestehend aus linearen oder verzweigten Alkyl- oder Alkenylketten mit 1 bis 12 Kohlenstoffatomen in der Hauptkette, wobei die Ketten mit Acryloxy-, Methacryloxy-, Succinyl-, Amino-, Hydroxyl-, Mercapto- und/oder Glycidyloxygruppen substituiert und/oder durch O- und/oder S-Atome und/oder eine NR'-Gruppe unterbrochen sein können, wobei R' die gleiche Bedeutung wie oben angegeben hat,
R" ausgewählt ist aus der Gruppe bestehend aus Halogenen, Hydroxylgruppen, Alkoxygruppen und/oder Acylgruppen mit 1 bis 4 Kohlenstoffatomen, und u = 0, 1, 2, 3; oder alternativ eine chemische Bindung an entsprechende Positionen D von benachbarten Monomeren der Formeln (IV) und/oder (V) darstellt,
A eine lineare und/oder verzweigte Alkylkette mit 1 bis 16 Kohlenstoffatomen oder Wasserstoff ist, und
die Verbindungen der allgemeinen Formeln (IV) und (V) in einem molaren Verhältnis von (IV):(V)= m/(100-m) enthalten sind, wobei m einen Wert im Bereich von 1 bis 99 und vorzugsweise von 60 bis 99 hat.

5. Kolloidale Beschichtungsdispersion nach einem der Ansprüche 1 bis 3, **dadurch gekennzeichnet, dass**,
die kolloidale Beschichtungsdispersion Additive enthält, vorzugsweise ausgewählt aus der Gruppe bestehend aus
• nicht-polymeren Bindemitteln, vorzugsweise SiO₂ oder Indium-Zinn-Oxid,
• Tenside, vorzugsweise Stearate, Dodecylbenzolsulfonate, Sulfatester, Sulfonatester, Phosphatester, Ethoxylate, Fettsäureester, Amine, Aminoxyde,
• polymere Bindemittel, bevorzugt anorganisch-organische Hybridpolymere, besonders bevorzugt herstellbar aus einem Präpolymer (a) mit über Kohlenstoff an Silicium gebundenen Gruppen mit organisch vernetzbaren oder organisch vernetzten Resten, besonders bevorzugt (Meth)acrylgruppen, Norbornenylgruppen oder Epoxygruppen, und/oder wobei das vernetzbare organische Monomer oder Präpolymer (b) mindestens eine Gruppe pro Molekül enthält, die eine oder mehrere C=C-Doppelbindungen aufweist, besonders bevorzugt Vinyl-, Acrylat-, Methacrylatgruppen, oder mindestens eine Epoxygruppe; und deren Mischungen,
besonders bevorzugt die Additive in einem Anteil von 1 bis 50 Gew.-%, bezogen auf die Gesamtmasse der kolloidalen Beschichtungsdispersion, enthalten sind.

6. Verfahren zur Herstellung der kolloidalen Beschichtungsdispersion nach einem der Ansprüche 1 bis 5, umfassend die folgenden Schritte:
(i) Bereitstellung mindestens eines wasserunlöslichen Monomers, ausgewählt aus der Gruppe bestehend aus Pyrrolderivaten, Thiophen, Thiophenderivaten oder deren Mischungen;
(ii) Bereitstellung mindestens eines Alkohols;
(iii) Lösen des wasserunlöslichen Monomers aus Schritt (i) in dem Alkohol aus Schritt (ii);
(iv) Zugabe von mindestens einem Oxidationsmittel vor, während oder nach Schritt (iii), um die Polymerisation des wasserunlöslichen Monomers einzuleiten;
(v) Polymerisation des wasserunlöslichen Monomers;
(vi) Entfernen des in Schritt (iv) zugegebenen Oxidationsmittels, um die Polymerisation zu stoppen und eine kolloidale Beschichtungsdispersion zu erhalten,
wobei Schritt (vi) durch Verdünnen der Mischung mit einem organischen Lösungsmittel und Rühren dieser Mischung, Zugabe von Wasser, um eine wässrige Phase und eine organische Phase zu erhalten, und Abtrennung der wässrigen Phase, die das Oxidationsmittel enthält, durchgeführt wird.

7. Verfahren nach Anspruch 6, **dadurch gekennzeichnet, dass**,
das molare Verhältnis zwischen dem mindestens einen wasserunlöslichen Monomer, das in Schritt (i) bereitgestellt wird, und dem mindestens einen Alkohol, der in Schritt (ii) bereitgestellt wird, von 1:25 bis 1:510, bevorzugt von 1:255 bis 1:510 und besonders bevorzugt 1:255 oder 1:25 beträgt; und/oder
das molare Verhältnis zwischen dem mindestens einen Oxidationsmittel, das in Schritt (iv) bereitgestellt wird, und dem mindestens einen wasserunlöslichen Monomer, das in Schritt (i) bereitgestellt wird, von 1:1,50 bis 1:3,00, bevorzugt von 1:1,75 bis 1:2,5 und besonders bevorzugt 1:2,25 beträgt; und/oder
Schritt (v) für einen Zeitraum von 1 bis 72 h, bevorzugt von 1 bis 6 h und besonders bevorzugt für 3 h in einem Temperaturbereich von - 12 bis 25°C durchgeführt wird, am meisten bevorzugt Schritt (v) durchgeführt wird, bis das Absorptionsmaximum des reduzierten Polymers im Bereich von 350 bis 650 nm, besonders bevorzugt im Bereich von 380 bis 650 nm und am meisten bevorzugt im Bereich von 400 bis 650 nm liegt.

8. Verfahren nach Anspruch 6 oder 7, **dadurch gekennzeichnet, dass**,
das wasserunlösliche Monomer ausgewählt ist aus der Gruppe bestehend aus Poly(3-hexylthiophen) oder seitenkettenmodifizierten Alkylen-3,4-dioxythiophenen, vorzugsweise Naphthalindiimid-funktionalisierten Alkylen-3,4-dioxythiophenen; oder seitenkettenmodifiziertem Alkylen-3,4-dioxythiophen und deren Mischungen; und/oder
der Alkohol ausgewählt ist aus der Gruppe bestehend aus Ethanol, n-Butanol, n-Heptanol und deren Mischungen; und/oder
ein oder mehrere zusätzliche(s) organische(s) Lösungsmittel optional verwendet wird/werden; und/oder
das Oxidationsmittel ausgewählt ist aus der Gruppe bestehend aus Eisen-(III)-Salzen, vorzugsweise Eisen-(III)-Chlorid, Eisen-(III)-Sulfat, Eisen(III)-Perchlorat, Eisen-(III)-butylnaphthalensulfonat, Eisen-(lll)-alkylsulfonate, Eisen-(III)-carboxylat, Eisen-(III)-camphersulfonat, Eisen-(III)-dodecylsulfonat, Eisen-(III)-Salze aromatischer Sulfonsäuren, vorzugsweise Eisen-(III)-Benzolsulfonat, Eisen-(III)-Dodecylbenzolsulfonat, Eisen-(III)-p-Toluolsulfonate und/oder Mischungen derselben, Wasserstoffperoxid, Dichromate, Peroxydisulfate, Perchlorate, Persulfate, Perborate, Permanganate und/oder Mischungen derselben.

9. Verfahren nach einem der Ansprüche 6 bis 8, **dadurch gekennzeichnet, dass**,
Schritt (vi) durchgeführt wird durch Verdünnen der Mischung mit einem organischen Lösungsmittel, vorzugsweise n-Heptanol, und Rühren dieser Mischung, Zugabe von Wasser, um eine wässrige Phase und eine organische Phase zu erhalten, und Abtrennung der wässrigen Phase, die das Oxidationsmittel enthält, wobei die Abfolge: Zugabe von Wasser und Abtrennung der wässrigen Phase mindestens dreimal wiederholt wird.

10. Verfahren nach Anspruch 9, **dadurch gekennzeichnet, dass**,
nach Schritt (vi) zumindest ein Alkohol, vorzugsweise n-Butanol, zugegeben wird, um den Feststoffgehalt im Bereich von 0,1 bis 20 Gew.-% und vorzugsweise von 1 bis 20 Gew.-%, bezogen auf das Gesamtgewicht der kolloidalen Beschichtungsdispersion, anzupassen, vorzugsweise die kolloidale Beschichtungsdispersion nach Zugabe des mindestens einen Alkohols kräftig gerührt wird und anschließend Agglomerate mit einer durchschnittlichen Teilchengröße > 5 pm durch Filtration entfernt werden.

11. Verfahren nach einem der Ansprüche 6 bis 10, **dadurch gekennzeichnet, dass**,
die Schritte (ii) bis (v) in einem Temperaturbereich von -5 bis - 15°C durchgeführt werden und/oder Schritt (v) über einen Zeitraum von 1,5 bis 4,5 Stunden durchgeführt wird; oder
das in Schritt (ii) bereitgestellte organische Lösungsmittel vorzugsweise n-Butanol ist, und/oder die Schritte (ii) bis (v) in einem Temperaturbereich von 15 bis 25°C durchgeführt werden, und/oder Schritt (v) über einen Zeitraum von 60 bis 80 Stunden durchgeführt wird.

12. Verfahren nach einem der Ansprüche 6 bis 11, **dadurch gekennzeichnet, dass**,
vor, nach oder während Schritt (v) Additive zugesetzt werden, diese Additive vorzugsweise ausgewählt sind aus der Gruppe bestehend aus nicht-polymeren Bindemitteln, Tensiden, polymeren Bindemitteln, anorganisch-organischen Hybridpolymeren und Mischungen derselben, besonders bevorzugt die Additive in einer Menge von 1 bis 50 Gew.-%, bezogen auf die Gesamtmasse der kolloidalen Beschichtungsdispersion, enthalten sind.

13. Verwendung der kolloidalen Beschichtungslösung nach den Ansprüchen 1 bis 5 zum Abscheiden mindestens einer elektrochromen Schicht auf einem Substrat.

14. Verwendung nach Anspruch 13, **dadurch gekennzeichnet, dass**
die Abscheidung durch Schleuderbeschichtung, Schlitzdüsenbeschichtung oder Druckprozesse durchgeführt wird; und/oder
das Substrat ausgewählt ist aus der Gruppe bestehend aus
• transparenten leitfähigen Kunststofffolien, noch weiter bevorzugt Polyester wie Polyethylenterephthalat, beschichtet mit einem transparenten leitfähigen Oxid, ausgewählt aus der Gruppe bestehend aus zinndotiertem Indiumoxid, fluordotiertem Zinnoxid, aluminiumdotiertem Zinkoxid, aluminiumdotiertem Zirkoniumoxid, antimondotiertem Zinnoxid, antimon-/zinndotiertem Zinkoxid, indium-/zinndotiertem Zinkoxid und/oder Mischungen derselben
• Glas, das mit einem transparenten leitfähigen Oxid beschichtet ist, ausgewählt aus der Gruppe bestehend aus zinndotiertem Indiumoxid, fluordotiertem Zinnoxid, aluminiumdotiertem Zinkoxid, aluminiumdotiertem Zirkoniumoxid, antimondotiertem Zinnoxid, antimon-/zinndotiertem Zinkoxid, indium-/zinndotiertem Zinkoxid und/oder Mischungen derselben,
• Metall, vorzugsweise Spiegelglanzmetalle, ausgewählt aus der Gruppe AI, Ni, Ag, Au, Pd, Pt, Cu und deren Legierungen, optional beschichtet mit einem transparenten leitfähigen Oxid, ausgewählt aus der Gruppe bestehend aus zinndotiertem Indiumoxid, fluordotiertem Zinnoxid, aluminiumdotiertem Zinkoxid, aluminiumdotiertem Zirkoniumoxid, antimondotiertem Zinnoxid, antimon-/zinndotiertem Zinkoxid, indium-/zinndotiertem Zinkoxid und/oder Mischungen derselben,
• Textilien und Gewebe, enthaltend leitfähige Komponenten, vorzugsweise Metalldrähte, oder ein leitfähiges Oxid, ausgewählt aus der Gruppe bestehend aus zinndotiertem Indiumoxid, fluordotiertem Zinnoxid, aluminiumdotiertem Zinkoxid, aluminiumdotiertem Zirkoniumoxid, antimondotiertem Zinnoxid, antimon-/zinndotiertem Zinkoxid, indium-/zinndotiertem Zinkoxid und/oder Mischungen derselben,
• Kunststofffolie, Glas, Metall und Gewebe, beschichtet mit einem eigenleitenden Polymer, vorzugsweise PEDOT:PSS und Kombinationen derselben;
• Kunststofffolie, Glas, Metall und Gewebe, beschichtet mit einem transparenten leitfähigen Oxid, ausgewählt aus der Gruppe bestehend aus zinndotiertem Indiumoxid, fluordotiertem Zinnoxid, aluminiumdotiertem Zinkoxid, aluminiumdotiertem Zirkoniumoxid, antimondotiertem Zinnoxid, antimon-/zinndotiertem Zinkoxid, indium-/zinndotiertem Zinkoxid und/oder Mischungen derselben und einem eigenleitenden Polymer, vorzugsweise PEDOT:PSS und Kombinationen derselben;
• Kunststofffolie, Glas, Metall und Gewebe, beschichtet mit einem transparenten Schichtstapel, der Isolator-/Metall-/Isolator-, Halbleiter-/Metall-/Isolator- oder Halbleiter-/Metall-/Halbleiterschichten oder mehrere derselben, ein optional über- oder unterbeschichtetes Metallnetz oder -gitter, eine optional über- oder unterbeschichtete Metall- oder Kohlenstoffnanodrahtabscheidung, Kohlenstoffnanoröhren, Graphen und Mischungen derselben umfasst.

15. Verwendung nach Anspruch 13 oder 14, **dadurch gekennzeichnet, dass**
die abgeschiedene Schicht in einer Anwendung verwendet wird, ausgewählt aus der Gruppe bestehend aus elektrochromen Einrichtungen, einer Elektronen-Akzeptorschicht oder einer Lochleiterschicht für organische Photovoltaik, einer leitfähigen Veredelung von Oberflächen und Geweben, einer aktiven Schicht einer Batteriekomponente/Elektrode, einer Lochleiterschicht in OLEDs, einer Kathodenschicht oder Abscheidung in Elektrolytkondensatoren oder einer Abscheidungsschicht in einem Sensor.

## Revendications

1. Dispersion de revêtement colloïdale comprenant des particules de polymère électrochromique ayant une taille moyenne de particule *d₅₀* dans la plage de 1 à 200 nm en tant que phase solide et au moins un alcool en tant que phase liquide ; dans laquelle
la teneur en matières solides de la dispersion de revêtement colloïdale est de 0,1 à 20 % en poids sur la base de la masse totale de la dispersion de revêtement colloïdale ; les particules de polymère électrochromique sont dérivées d'un monomère insoluble dans l'eau choisi dans le groupe constitué par les dérivés de pyrrole, le thiophène, les dérivés de thiophène ou leurs mélanges ; et la solution de revêtement colloïdale contient un maximum de 5 % en poids de stabilisants et d'agents dispersants.

2. Dispersion de revêtement colloïdale selon la revendication 1, **caractérisée en ce que**,
la taille moyenne de particule *dₛₒ* des particules de polymère électrochromique est dans la plage de 10 à 200 nm, de préférence de 10 à 100 nm et plus préférentiellement de 10 à 50 nm ; et/ou
la teneur en matières solides de la dispersion colloïdale est de 0,5 à 10 % en poids, de préférence de 1 à 7,5 % en poids et plus préférentiellement de 1 à 5 % en poids sur la base de la masse totale de la dispersion de revêtement colloïdale.

3. Dispersion de revêtement colloïdale selon la revendication 1 ou 2, **caractérisée en ce que**,
le monomère insoluble dans l'eau est choisi dans le groupe constitué par le poly(3-hexylthiophène), ou les alkylène-3,4-dioxythiophènes à chaîne latérale modifiée, de préférence l'éthylène-3,4-dioxythiophène ou le propylène-3,4-dioxythiophène ou leurs mélanges, plus préférentiellement les éthylène-3,4-dioxythiophènes fonctionnalisés par naphtalènediimide ; ou l'alkylène-3,4-dioxythiophène à chaîne latérale modifiée, de préférence l'éthylène-3,4-dioxythiophène, le propylène-3,4-dioxythiophène ou leurs mélanges.

4. Dispersion de revêtement colloïdale selon la revendication 3, **caractérisée en ce que**,
l'alkylène-3,4-dioxythiophène à chaîne latérale modifiée comprend les motifs selon les formules générales (IV) et (V) suivantes 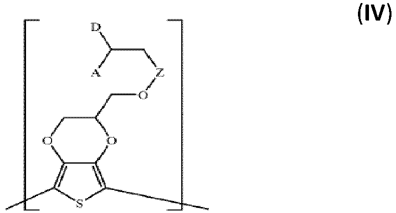 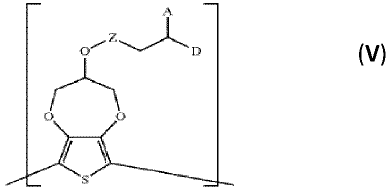
où
Z est choisi dans le groupe constitué par les éléments structurels - R-, -C(O)-R- et -C(O)-NH-R-, -CH₂-C(O)O-R-, où R est une chaîne alkylène linéaire et/ou ramifiée ayant 1 à 16 atomes de carbone, D est choisi dans le groupe constitué par H, -SiR'ᵤ(R")₃₋ᵤ, -S-R- SiR'ᵤ(R")₃₋ᵤ, et R a la même signification qu'indiquée plus haut, de préférence D = H,
R' est choisi dans le groupe constitué par les chaînes alkyle ou alcényle linéaires ou ramifiées ayant 1 à 12 atomes de carbone dans la chaîne principale, où les chaînes peuvent être substituées par des groupes acryloxy, méthacryloxy, succinyle, amino, hydroxyle, mercapto, et/ou glycidyloxy et/ou interrompues par des atomes de O et/ou de S et/ou un groupe NR', où R' a la même signification qu'indiquée plus haut,
R" est choisi dans le groupe constitué par les halogènes, les groupes hydroxyle, les groupes alcoxy et/ou les groupes acyle ayant 1 à 4 atomes de carbone, et u = 0, 1, 2, 3 ; ou en variante représente une liaison chimique aux positions D correspondantes de monomères voisins des formules (IV) et/ou (V),
A est une chaîne alkyle linéaire et/ou ramifiée ayant 1 à 16 atomes de carbone ou hydrogène, et
les composés des formules générales (IV) et (V) sont compris dans un rapport molaire de (IV):(V) = m/(100-m), où m a une valeur dans la plage de 1 à 99 et de préférence de 60 à 99.

5. Dispersion de revêtement colloïdale selon l'une quelconque des revendications 1 à 3, **caractérisée en ce que**,
la dispersion de revêtement colloïdale comprend des additifs, de préférence choisis dans le groupe constitué par
• des matières liantes non polymères, de préférence SiO₂ ou l'oxyde d'indium et d'étain,
• des tensioactifs, de préférence les stéarates, les dodécylben-zènesulfonates, les esters de sulfate, les esters de sulfonate, les esters de phosphate, les éthoxylates, les esters d'acides gras, les amines, les oxydes d'amine,
• des liants polymères, de préférence les polymères hybrides inorganiques-organiques, plus préférentiellement pouvant être produits à partir d'un prépolymère (a) ayant des groupes, qui sont liés au silicium par l'intermédiaire du carbone, avec des fractions organiquement réticulables ou organiquement réticulées, plus préférentiellement des groupes (méth)acrylique, des groupes norbornényle ou des groupes époxy, et/ou le monomère ou prépolymère organique réticulable (b) contient au moins un groupe par molécule qui a une ou plusieurs doubles liaisons C=C, plus préférentiellement des groupes vinyle, acrylate, méthacrylate, ou au moins un groupe époxy ; et des mélanges de ceux-ci,
plus préférentiellement les additifs sont contenus à 1 à 50 % en poids sur la base de la masse totale de la dispersion de revêtement colloïdale.

6. Procédé de fabrication d'une dispersion de revêtement colloïdale selon l'une quelconque des revendications 1 à 5, comprenant les étapes suivantes :
(i) la fourniture d'au moins un monomère insoluble dans l'eau choisi dans le groupe constitué par les dérivés de pyrrole, le thiophène, les dérivés de thiophène ou leurs mélanges ;
(ii) la fourniture d'au moins un alcool ;
(iii) la dissolution du monomère insoluble dans l'eau issu de l'étape (i) dans l'alcool issu de l'étape (ii) ;
(iv) l'addition d'au moins un agent oxydant avant, pendant ou après l'étape (iii) pour déclencher la polymérisation du monomère insoluble dans l'eau ;
(v) la polymérisation du monomère insoluble dans l'eau ;
(vi) l'élimination de l'agent oxydant ajouté à l'étape (iv) pour arrêter la polymérisation et obtenir une dispersion de revêtement colloïdale,
dans lequel l'étape (vi) est effectuée par dilution du mélange avec un solvant organique et agitation du mélange, addition d'eau pour obtenir une phase aqueuse et une phase organique, et séparation de la phase aqueuse contenant l'agent oxydant.

7. Procédé selon la revendication 6, **caractérisé en ce que**,
le rapport molaire entre l'au moins un monomère insoluble dans l'eau fourni à l'étape (i) et l'au moins un alcool fourni à l'étape (ii) est de 1 : 25 à 1 : 510, de préférence de 1 : 255 à 1 : 510 et plus préférentiellement de 1 : 255 ou 1 :25 ; et/ou
le rapport molaire entre l'au moins un agent oxydant fourni à l'étape (iv) et l'au moins un monomère insoluble dans l'eau fourni à l'étape (i) est de 1 : 1,50 à 1 : 3,00, de préférence de 1 : 1,75 à 1 : 2,5 et plus préférentiellement de 1 : 2,25 ; et/ou
l'étape (v) est effectuée pendant une période de 1 à 72 h, de préférence de 1 à 6 h et plus préférentiellement pendant 3 h dans une plage de températures de -12 à 25 °C, le plus préférentiellement l'étape (v) est effectuée jusqu'à ce que le maximum d'absorption du polymère réduit soit dans la plage de 350 à 650 nm, plus préférentiellement dans la plage de 380 à 650 nm et le plus préférentiellement de 400 à 650 nm.

8. Procédé selon la revendication 6 ou 7, **caractérisé en ce que**,
le monomère insoluble dans l'eau est choisi dans le groupe constitué par le poly(3-hexylthiophène), ou les alkylène-3,4-dioxythiophènes à chaîne latérale modifiée, de préférence les alkylène-3,4-dioxythiophènes fonctionnalisés par naphtalènediimide ; ou les alkylène-3,4-dioxythiophènes à chaîne latérale modifiée et des mélanges de ceux-ci ; et/ou
l'alcool est choisi dans le groupe constitué par l'éthanol, le n-butanol, le n-heptanol et des mélanges de ceux-ci ; et/ou
un ou plusieurs solvant(s) organique(s) supplémentaire(s) est(sont) éventuellement utilisé(s) ; et/ou
l'agent oxydant est choisi dans le groupe constitué par les sels de fer(lll), de préférence le chlorure de fer(lll), le sulfate de fer(III), le perchlorate de fer(lll), le butylnaphtènesulfonate de fer (III), les alkylsulfonates de fer(III), le carboxylate de fer(III), le camphorsulfonate de fer(lll), le dodécylsulfonate de fer(III), les sels d'acides sulfoniques aromatiques, de préférence le benzènesulfonate de fer(III), le dodécyl-benzènesulfonate de fer (III), les p-toluènesulfonates de fer (III) et/ou des mélanges de ceux-ci, le peroxyde d'hydrogène, les bichromates, les peroxydisulfates, les perchlorates, les persulfates, les perborates, les permanganates et/ou des mélanges de ceux-ci.

9. Procédé selon l'une quelconque des revendications 6 à 8, **caractérisé en ce que**,
l'étape (vi) est effectuée par dilution du mélange avec un solvant organique, de préférence le n-heptanol et agitation de ce mélange, addition d'eau pour obtenir une phase aqueuse et une phase organique, et séparation de la phase aqueuse contenant l'agent oxydant, la séquence : addition d'eau et séparation de la phase aqueuse est répétée au moins trois fois.

10. Procédé selon la revendication 9, **caractérisé en ce que**,
après l'étape (vi), au moins un alcool, de préférence le n-butanol, est ajouté pour ajuster la teneur en matières solides dans la plage de 0,1 à 20 % en poids et de préférence de 1 à 20 % en poids sur la base du poids total de la dispersion de revêtement colloïdale, de préférence la dispersion de revêtement colloïdale est agitée vigoureusement après addition d'au moins un alcool et par la suite, les agglomérats ayant une taille moyenne de particule > 5 µm sont éliminés par filtration.

11. Procédé selon l'une quelconque des revendications 6 à 10, **caractérisé en ce que**,
les étapes (ii) à (v) sont réalisées dans une plage de températures de -5 à -15 °C, et/ou l'étape (v) est réalisée sur une période de 1,5 à 4,5 heures ; ou
le solvant organique fourni à l'étape (ii) est de préférence le n-butanol, et/ou les étapes (ii) à (v) sont réalisées dans une plage de températures de 15 à 25 °C, et/ou l'étape (v) est réalisée sur une période de 60 à 80 heures.

12. Procédé selon l'une quelconque des revendications 6 à 11, **caractérisé en ce que**,
des additifs sont ajoutés avant, après ou pendant l'étape (v), ces additifs sont de préférence choisis dans le groupe constitué par les matières liantes non polymères, les tensioactifs, les liants polymères, les polymères hybrides inorganiques-organiques et des mélanges de ceux-ci, plus préférentiellement les additifs sont contenus à 1 à 50 % en poids sur la base de la masse totale de la dispersion de revêtement colloïdale.

13. Utilisation de la solution de revêtement colloïdale selon les revendications 1 à 5 pour le dépôt d'au moins une couche électrochromique sur un substrat.

14. Utilisation selon la revendication 13, **caractérisée en ce que**,
le dépôt est effectué par des processus de dépôt à la tournette, enduction par filière à fente ou impression ; et/ou
le substrat est choisi dans le groupe constitué par
• les films plastiques conducteurs transparents, de préférence les polyesters tels que le polytéréphtalate d'éthylène, revêtus d'un oxyde conducteur transparent choisi dans le groupe constitué par l'oxyde d'indium dopé à l'étain, l'oxyde d'étain dopé au fluor, l'oxyde de zinc dopé à l'aluminium, l'oxyde de zirconium dopé à l'aluminium, l'oxyde d'étain dopé à l'antimoine, l'oxyde de zinc dopé à l'antimoine/étain, l'oxyde de zinc dopé à l'indium/étain, et/ou des mélanges de ceux-ci,
• du verre revêtu d'un oxyde conducteur transparent choisi dans le groupe constitué par l'oxyde d'indium dopé à l'étain, l'oxyde d'étain dopé au fluor, l'oxyde de zinc dopé à l'aluminium, l'oxyde de zirconium dopé à l'aluminium, l'oxyde d'étain dopé à l'antimoine, l'oxyde de zinc dopé à l'antimoine/étain, l'oxyde de zinc dopé à l'indium/étain, et/ou des mélanges de ceux-ci,
• du métal, de préférence des miroirs choisis dans le groupe de Al, Ni, Ag, Au, Pd, Pt, Cu et des alliages de ceux-ci, éventuellement revêtu d'un oxyde conducteur transparent choisi dans le groupe constitué par l'oxyde d'indium dopé à l'étain, l'oxyde d'étain dopé au fluor, l'oxyde de zinc dopé à l'aluminium, l'oxyde de zirconium dopé à l'aluminium, l'oxyde d'étain dopé à l'antimoine, l'oxyde de zinc dopé à l'antimoine/étain, l'oxyde de zinc dopé à l'indium/étain, et/ou des mélanges de ceux-ci,
• des textiles et étoffes comprenant des composants conducteurs, de préférence des fils métalliques, ou un oxyde conducteur choisi dans le groupe constitué par l'oxyde d'indium dopé à l'étain, l'oxyde d'étain dopé au fluor, l'oxyde de zinc dopé à l'aluminium, l'oxyde de zirconium dopé à l'aluminium, l'oxyde d'étain dopé à l'antimoine, l'oxyde de zinc dopé à l'antimoine/étain, l'oxyde de zinc dopé à l'indium/étain, et/ou des mélanges de ceux-ci,
• un film plastique, du verre, du métal, des étoffes revêtus d'un polymère intrinsèquement conducteur, de préférence PEDOT:PSS et des combinaisons de ceux-ci ;
• un film plastique, du verre, du métal, et des étoffes revêtus d'un oxyde conducteur transparent choisi dans le groupe constitué par l'oxyde d'indium dopé à l'étain, l'oxyde d'étain dopé au fluor, l'oxyde de zinc dopé à l'aluminium, l'oxyde de zirconium dopé à l'aluminium, l'oxyde d'étain dopé à l'antimoine, l'oxyde de zinc dopé à l'antimoine/étain, l'oxyde de zinc dopé à l'indium/étain, et/ou des mélanges de ceux-ci, et d'un polymère intrinsèquement conducteur, de préférence PEDOT:PSS et des combinaisons de ceux-ci ;
• un film plastique, du verre, du métal, et des étoffes revêtus d'un empilement de couches transparentes comprenant des couches isolant/métal/isolant, semiconducteur/métal/isolant ou semiconducteur/métal/semiconducteur ou des multiples de celles-ci, d'un treillis ou quadrillage métallique éventuellement à revêtement supérieur ou inférieur, d'un dépôt de nanofils en métal ou en carbone éventuellement à revêtement supérieur ou inférieur, de nanotubes de carbone, de graphène et de mélanges de ceux-ci.

15. Utilisation selon la revendication 13 ou 14, **caractérisée en ce que**,
la couche déposée est utilisée dans une application choisie dans le groupe constitué par les dispositifs électrochromiques, une couche d'accepteurs d'électrons ou une couche de conducteurs de trous pour la photovoltaïque organique, une finition conductrice de surfaces et d'étoffes, une couche active d'un composant de batterie/d'une électrode, une couche de conducteurs de trous dans les DELO, une couche de cathode ou un dépôt dans les condensateurs électrolytiques ou une couche de dépôt dans un capteur.
